(19) Europäisches Patentamt

European Patent Office

Office européen des brevets

(11) **EP 1 111 776 A1**

(12) **EUROPEAN PATENT APPLICATION**
published in accordance with Art. 158(3) EPC

(43) Date of publication:
**27.06.2001 Bulletin 2001/26**

(51) Int Cl.⁷: **H03G 3/12**, H03G 3/02,
H03F 3/45

(21) Application number: **98941693.8**

(22) Date of filing: **03.09.1998**

(86) International application number:
**PCT/JP98/03944**

(87) International publication number:
**WO 00/14871 (16.03.2000 Gazette 2000/11)**

(84) Designated Contracting States:
**DE FR GB**

(71) Applicants:
• **Toa Corporation**
**Kobe-Shi, Hyogo 650-0046 (JP)**
• **B.B.M. Electronics Group Limited**
**Morden, Surrey SM4 4LP (GB)**

(72) Inventors:
• **BAKER, Steve B.B.M. Electronics Group Limited**
**Morden Surrey SW4 4LP (GB)**

• **GANLEY, Richard**
**B.B.M. Electronics Group Limited**
**Morden Surrey SM4 4LP (GB)**

(74) Representative: **HOFFMANN - EITLE**
**Patent- und Rechtsanwälte**
**Arabellastrasse 4**
**81925 München (DE)**

(54) **NOISE INFLUENCE-REDUCED AMPLIFIER**

(57)    A differential amplifier comprises a first operational amplifier having a non-inverting input terminal for receiving a first input signal and an inverting input terminal for receiving a second input signal, a potentiometer including a plurality of series connected resistors for dividing an output of the first operational amplifier and for selecting a different combination of the plurality of resistors, and a manipulation member for selecting a gain for the differential amplifier. A voltage outputted from the potentiometer is fed back to the inverting input terminal of the first operational amplifier through a second operational amplifier. An instruction signal for specifying a combination of resistors in the potentiometer is generated from a signal generator corresponding to a gain selected by the manipulating member.

Fig. 2

**Description**

TECHNICAL FIELD OF THE INVENTION

This invention relates to an amplifier which is capable of reducing any influence by noise by using a digital potentiometer.

BACKGROUND ART

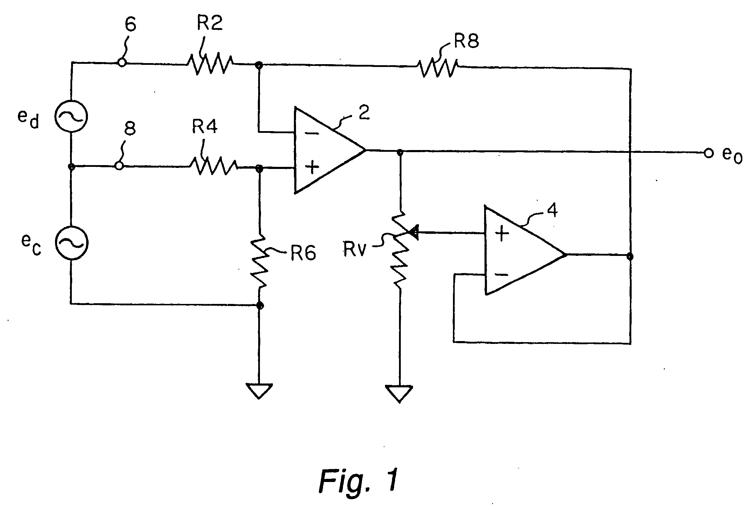

As is well known, a characteristic of a differential amplifier is to have a large common mode rejection ratio (CMRR), i.e., to have a large gain for a differential mode of signals supplied to an inverting input and a non-inverting input, respectively, and to have a small gain for a common mode component. For this reason, differential amplifiers are widely utilized in a variety of fields.
When such a differential amplifier is implemented by an operational amplifier having a single-ended output form, this inevitably requires complicated operations. Specifically, at least two resistors must be varied in a sophisticated manner to change the gain, and the resistors must be adjusted a large number of times to realize a desired gain. Therefore, a variety of differential amplifiers of differential input, differential output type have been devised as differential amplifiers which can adjust the gain only by varying the value of a single resistor. Several examples have been presented in a magazine "Transistor Gijutsu, November 1980," (No. 11, Vol. 17), page 336, published on November 1, 1980 in Japan. One of them is explained with reference to Fig. 1.
In Fig. 1, a differential amplifier comprises a first operational amplifier 2 and a second operational amplifier 4, where the first operational amplifier 2 has an inverting input terminal connected to an input terminal 6 through a resistor R2. The first operational amplifier 2 has a non-inverting input terminal connected to the other input terminal 8 through a resistor R4 and also grounded through a resistor R6.
The first operational amplifier 2 has an output terminal grounded through a variable resistor Rv, and the variable resistor Rv has a movable terminal connected to a non-inverting input terminal of the second operational amplifier 4. The second operational amplifier 4 has an output terminal connected to its inverting input terminal and also connected to the inverting input terminal of the first operational amplifier 2 through a resistor R8. In an actual circuit configuration, the resistor R2 and the resistor R4 are set to have the same value, while the resistor R6 and the resistor R8 are also set to have the same value.
In this circuit, a division ratio by the variable resistor Rv is assumed to be K ($0<K\leqq1$). In other words, a resistance value between the output terminal of the first operational amplifier 2 and the movable terminal of the variable resistor Rv is represented by $(1-K)Rv$, and a resistance value between the movable terminal of the variable resistor Rv and the ground is represented by $KRv$. Assuming herein that an input AC signal applied between the inverting input terminal and the non-inverting input terminal of the first operational amplifier 2 has a differential mode voltage $e_d$ and a common mode voltage $e_c$, and the operational amplifier 4 at the second stage has an output voltage $e_o$,

$$e_o/e_d = -(R2/R1) \cdot (1/K)$$

is satisfied. This equation indicates that the gain $e_o/e_d$ of the differential amplifier of Fig. 1 changes inversely proportional to the division ratio K of the variable resistor Rv.
When the differential amplifier illustrated in Fig. 1 is incorporated in an actual device, the variable resistor Rv and its manipulating knob are generally integrated with each other, so that the variable resistor Rv must be positioned on or near a manipulation panel of the device. For this reason, the first operational amplifier 2 and the second operational amplifier 4 may be positioned away from the variable resistor Rv, depending on how circuit components are arranged, thus causing a problem that long wires need be laid to connect between them. As a result of the longer wires, the circuit becomes more susceptible to the influence by noise, thus leading to another problem that the S/N ratio of the differential amplifier is deteriorated. Particularly, a device having limitations to the arrangement of circuit components, such as a compact portable device, also has a problem that the size of the device itself is increased for ensuring a space for laying wires from the variable resistor Rv to other circuit components.

DISCLOSURE OF THE INVENTION

This invention has been proposed to solve the above-mentioned problem inherent to conventional differential amplifiers, and it is an object of the present invention to provide an amplifier which is less susceptible to the influence by noise.

BRIEF DESCRIPTION OF DRAWINGS

Fig. 1 is a block diagram illustrating the configuration of a conventional differential amplifier;
Fig. 2 is a block diagram illustrating the configuration of an embodiment of a differential amplifier according to the present invention; and
Fig. 3 illustrates an example of a digital potentiometer for use in the differential amplifier of Fig. 2.

BEST MODE FOR IMPLEMENTING THE INVENTION

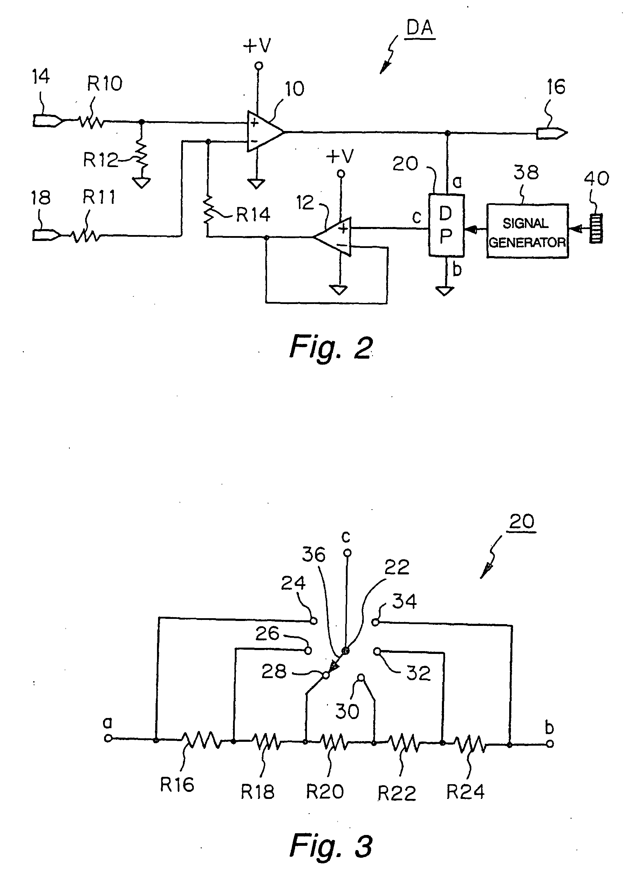

One embodiment of a differential amplifier according to the present invention will hereinafter be described in detail with reference to Fig. 2 and Fig. 3. In Fig. 2, a differential amplifier DA has a first operational amplifier 10 and a second operational amplifier 12. The first operational amplifier 10 has a non-inverting input terminal connected to a first input port 14 through a resistor R10, and also grounded through a resistor R12. Also, the first operational amplifier 10 has an output terminal connected to an output port 16. Generally, the first operational amplifier 10 and the second operational amplifier 12 are of the same type, and have their power source terminals connected to a DC voltage source +V.

On the other hand, the first operational amplifier 10 has an inverting input terminal connected to a second input port 18 through a resistor R11, and also connected to an output terminal of the second operational amplifier 12 through a resistor R14. The second operational amplifier 12 has an inverting input terminal and the output terminal directly coupled, while a non-inverting input terminal of the second operational amplifier 12 is connected to a terminal $c$ of a digital potentiometer 20. The digital potentiometer 20 has a terminal $a$ connected to the output terminal of the first operational amplifier 10 and a terminal $b$ grounded.

Now, the configuration of the digital potentiometer 20 illustrated in Fig. 2 is explained with reference to Fig. 3. The digital potentiometer 20 has a plurality of resistors R16, R18, R20, R22, R24 (five in Fig. 3) connected in series between the terminal $a$ and the terminal $b$. As mentioned above, a movable contact 22 of the digital potentiometer 20 is connected to the non-inverting input terminal of the second operational amplifier 12.

As illustrated in Fig. 2, a junction point between the terminal $a$ and the resistor R16 is connected to a first fixed contact 24; a junction point between the resistor 16 and the resistor 18 is connected to a second fixed contact 26; a junction point between the resistor 18 and the resistor 20 is connected to a third fixed contact 28; a junction point between the resistor R20 and the resistor R22 is connected to a fourth fixed contact 30; a junction point between the resistor R22 and the resistor R24 is connected to a fifth fixed contact 32; and a junction point between the resistor 24 and the terminal $b$ is connected to a sixth fixed point 34.

The movable terminal 36 of the digital potentiometer 20 is connected to one of the six fixed contacts 24 - 34, thereby dividing an output voltage of the first operational amplifier 10 with an appropriate division ratio K. The gain of the differential amplifier DA is inversely proportional to the division ratio K of the digital potentiometer 20.

In Fig. 2 and Fig. 3, the position of the movable terminal 36 of the digital potentiometer 20 is controlled by a switching instruction signal supplied from a signal generator 38. The signal generator 38 is coupled to a rotatable or linearly movable manipulating member 40.

Now, the operation of the differential amplifier DA of Fig. 2 is explained. When the gain of the differential amplifier DA is set to a desired value, the user may rotate or move the manipulating member 40 to a position representative of the desired gain to be set to the differential amplifier DA. Corresponding to the amount of rotation or the amount of movement of the manipulating member 40, a switching instruction signal for indicating a set gain value is generated from the signal generator 38 and applied to the digital potentiometer 20. Here, the movable terminal 36 of the digital potentiometer 20 moves to one of the six fixed contacts 24 - 34, for example, to the fixed contact 28 in response to the applied switching instruction signal. As a result, a division ratio K for realizing the desired gain for the differential amplifier DA is set in the digital potentiometer 20.

In the differential amplifier DA illustrated in Fig. 2, since the potentiometer 20 can be positioned near circuit components including the first operational amplifier 10 and the second operational amplifier 12, the digital potentiometer 20 can be connected to other circuit components with shorter leads. For this reason, the amount of noise caught by the leads connecting between the digital potentiometer 20 and other circuit components is largely reduced as compared with the conventional differential amplifier illustrated in Fig. 1, and moreover, the manipulating member 40 can be arranged at an arbitrary position on a manipulation panel (not shown). Since the digital potentiometer 20 and the manipulating member 40 are only required to be electrically connected, the degree of freedom in circuit arrangement is increased, thereby making it possible to dispose the differential amplifier DA away from a noise source. From this aspect, the differential amplifier DA is less susceptible to the influence by noise.

Further, since the division ratio of the digital potentiometer 20 is controlled by the switching instruction signal from the signal generator 38, a plurality of look-up tables having recorded therein combinations of the amount of rotation or the amount of movement of the manipulation member 40 and the switching instruction signal corresponding to a plurality of different gains available to the differential amplifier DA may have been previously prepared for each of different combinations, thereby making it possible to realize a desired division ratio by changing the setting of the signal generator 38 in accordance of intended uses.

INDUSTRIAL AVAILABILITY

Since the differential amplifier according to this invention can largely reduce noise while properly maintaining the common mode rejection ratio, it is advantageously utilized as a balanced gain means in audio devices.

**Claims**

**1.**    A differential amplifier in which an output signal of a differential input type operational amplifier is divided and the divided output signal is fed back to an input of said operational amplifier, characterized by comprising:

changing means connected to an output terminal of said operational amplifier and capable of digitally changing a resistance division ratio in response to a manipulation of a user; and feed-back means for feeding an output signal of said changing means to the input of said operational amplifier.

2. A differential amplifier according to claim 1, characterized in that:
said changing means includes:

signal generating means operated by the user for outputting an instruction signal for specifying said resistance division ratio; and division ratio setting means having a plurality of preset different resistance division ratios for selecting said resistance division ratio therefrom in response to said instruction signal.

3. A differential amplifier according to claim 2, characterized in that:
said division ratio setting means includes:

a resistor circuit having a plurality of resistors connected in series; and movable means driven by said instruction signal for selecting a different combination of said resistors in response to said instruction signal.

4. A differential amplifier characterized by comprising:

a first operational amplifier having a non-inverting input terminal for receiving a first input signal and an inverting input terminal for receiving a second input signal; a potentiometer including a plurality of series connected resistors for dividing an output of said first operational amplifier, said potentiometer capable of selecting a different combination of said plurality of resistors; a second operational amplifier for receiving a voltage outputted from said potentiometer to feed back said voltage to said inverting input terminal of said first operational amplifier; manipulating means for selecting a gain for said differential amplifier; and signal generating means for generating an instruction signal for specifying a combination of said resistors in said potentiometer corresponding to the gain selected by said manipulating means.

5. A differential amplifier according to claim 4, characterized in that said signal generating means includes a look-up table for different combinations of manipulating amounts of said manipulating means and said instruction signal corresponding to a plurality of different gains available to said differential amplifier.

$e_0$

R8

R2

R4

R6

Rv

$e_d$

$e_c$

2

4

6

8

*Fig. 1*

Fig. 2

Fig. 3

## INTERNATIONAL SEARCH REPORT

| International application No. |
| --- |
| PCT/JP98/03944 |

**A. CLASSIFICATION OF SUBJECT MATTER**
Int.Cl⁶ H03G3/12, H03G3/02, H03F3/45

According to International Patent Classification (IPC) or to both national classification and IPC

**B. FIELDS SEARCHED**

Minimum documentation searched (classification system followed by classification symbols)
Int.Cl⁶ H03G3/12, H03G3/02, H03F3/45

Documentation searched other than minimum documentation to the extent that such documents are included in the fields searched

| | | | |
| --- | --- | --- | --- |
| Jitsuyo Shinan Koho | 1922-1996 | Toroku Jitsuyo Shinan Koho | 1994-1998 |
| Kokai Jitsuyo Shinan Koho | 1971-1998 | Jitsuyo Shinan Toroku Koho | 1996-1998 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP, 61-90506, A (Meidensha Corp.), 8 May, 1986 (08. 05. 86), Page 2, lower left column, line 12 to lower right column, line 13 ; Fig. 1 (Family: none) | 1-5 |
| Y | JP, 61-187407, A (NEC Corp.), 21 August, 1986 (21. 08. 86), Fig. 1 (Family: none) | 1, 2 |
| Y | JP, 63-513, U (Toshiba Corp.), 5 January, 1988 (05. 01. 88), Fig. 1 (Family: none) | 1-5 |
| Y | JP, 7-46066, A (Matsushita Electric Works, Ltd.), 14 February, 1995 (14. 02. 95), Page 3, left column, line 25 to right column, line 37 ; Fig. 1 (Family: none) | 1-4 |
| Y | JP, 5-95239, A (Sony Corp.), 16 April, 1993 (16. 04. 93), Fig. 4 (Family: none) | 1-4 |

[x] Further documents are listed in the continuation of Box C.    [ ] See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | |
| | | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 1 December, 1998 (01. 12. 98) | 15 December, 1998 (15. 12. 98) |

| Name and mailing address of the ISA/ | Authorized officer |
| --- | --- |
| Japanese Patent Office | |
| Facsimile No. | Telephone No. |

Form PCT/ISA/210 (second sheet) (July 1992)

7

INTERNATIONAL SEARCH REPORT

International application No.

PCT/JP98/03944

C (Continuation).  DOCUMENTS CONSIDERED TO BE RELEVANT

| Category* | Citation of document, with indication, where appropriate, of the relevant passages | Relevant to claim No. |
|---|---|---|
| Y | JP, 58-132416, U  (Toyo Tsushin Kogyo K.K.), 7 September, 1983 (07. 09. 83), Fig. 2  (Family: none) | 5 |

Form PCT/ISA/210 (continuation of second sheet) (July 1992)

8